(19) Europäisches Patentamt
European Patent Office
Office européen des brevets

(11) **EP 3 858 923 A1**

(12) **EUROPEAN PATENT APPLICATION**
published in accordance with Art. 153(4) EPC


(43) Date of publication:
**04.08.2021 Bulletin 2021/31**

(21) Application number: **19866537.4**

(22) Date of filing: **27.09.2019**

(51) Int Cl.:
***C08L 101/12*** *(2006.01)* ***C08K 3/00*** *(2018.01)*
***C08K 5/00*** *(2006.01)* ***C08L 63/00*** *(2006.01)*
***C08L 83/04*** *(2006.01)* ***H01L 33/56*** *(2010.01)*

(86) International application number:
**PCT/JP2019/038425**

(87) International publication number:
**WO 2020/067544 (02.04.2020 Gazette 2020/14)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **28.09.2018 JP 2018185893**



(71) Applicant: **NITTO DENKO CORPORATION**
**Ibaraki-shi**
**Osaka 567-8680 (JP)**

(72) Inventors:
- **WENG, Yufeng**
  **Ibaraki-shi, Osaka 567-8680 (JP)**
- **FUJII, Hironaka**
  **Ibaraki-shi, Osaka 567-8680 (JP)**

(74) Representative: **Hoffmann Eitle**
**Patent- und Rechtsanwälte PartmbB**
**Arabellastraße 30**
**81925 München (DE)**


(54) **RESIN COMPOSITION, OPTICAL SEMICONDUCTOR ELEMENT, AND OPTICAL SEMICONDUCTOR DEVICE**


(57) The present invention relates to a resin composition containing a transparent resin and a light absorber, wherein a cured product of the resin composition has an absorption maximum wavelength in a wavelength range of 550 to 720 nm.


Fig. 6

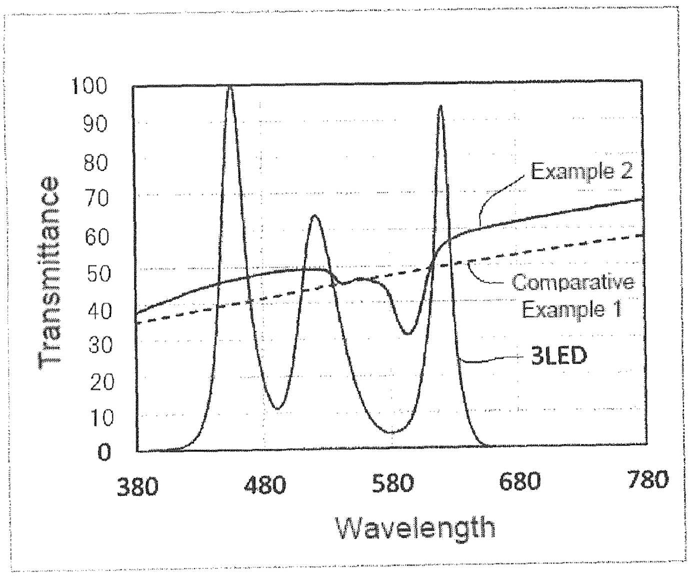


EP 3 858 923 A1

## Description

### Technical Field

The present invention relates to a resin composition used in encapsulation and the like of an optical semiconductor element, and an optical semiconductor element and optical semiconductor device using the resin composition.

### Background Art

A white optical semiconductor device is conventionally known as an optical semiconductor device that can emit high energy light. For example, a diode substrate supplying electric power to LED, LED (light emitting diode) emitting blue light mounted on the diode substrate, and a phosphor layer that can convert blue light into yellow light and covers LED are provided on the white optical semiconductor device. The white optical semiconductor device emits high energy white light by mixed colors of blue light emitted from LED and transmitted through the phosphor layer and yellow light in which a part of blue light has been wavelength-converted in the phosphor layer. Alternatively, the white optical semiconductor device is provided with a diode substrate supplying electric power to LED, and LED of three-colors R, G and B mounted on the diode substrate. High energy white light is emitted by mixed colors of lights from LED of three-colors R, G and B.

In general, a yellow phosphor is often used as a phosphor in a phosphor layer. For this reason, chromaticity of the optical semiconductor light-emitting device shifts from an achromatic point to a yellowish direction when turning off the light, yellowish color is appeared, and appearance such as designability is deteriorated. Furthermore, even in a white optical semiconductor device mounting three-colors LED, color of LED chip and reflected light from a frame and an electrode are appeared, and appearance such as designability is deteriorated. Therefore, the improvement in hue is required such that an optical semiconductor device shows more neutral black when turning off the light.

Uses of an optical semiconductor device are rapidly expanded in, for example, the mounting on indoor/outdoor large-sized televisions and large-sized monitors, and demands for high luminance, high color reproducibility and high contrast are increasing.

Patent Document 1 describes that display contrast can be dramatically improved by coloring the uppermost layer of LED element with a pigment of dark color such as black.

On the other hand, as a method for manufacturing an optical semiconductor device, a method of encapsulating one or more semiconductor chips fixed to a substrate or the like with an encapsulating resin, and then dicing the encapsulant so as to form a package for each semiconductor device. As an encapsulating material of the optical semiconductor device, resin compositions having excellent heat resistance, shock resistance, transparency and the like are generally used.

### Related Art

### Patent Document

Patent Document 1: JP-A-2003-086846

### Disclosure of Invention

### Problems to Be Solved by the Invention

However, in the technology described in Patent Document 1, when the uppermost layer of LED element has been encapsulated with a resin composition containing dark color pigment, this brings about reduction in brightness when turning off the light, and additionally color tone of black shifts when turning off the light. Thus, the improvement in hue was not sufficient.

The present invention has an object to provide a resin composition that can obtain a cured product further improving hue so as to show neutral black when turning off the light of an optical semiconductor device, enhancing display contrast and having light transmittance, and an optical semiconductor element and optical semiconductor device using the resin composition.

### Means for Solving the Problems

As a result of intensive investigations to solve the above problems, the present inventors have found that the above problems can be solved by using a resin composition capable of forming a cured product having an absorption

maximum wavelength in a wavelength range of 550 to 720 nm, and have completed the present invention.

Namely, one aspect of the present invention relates to a resin composition containing a transparent resin and a light absorber, wherein a cured product of the resin composition has an absorption maximum wavelength in a wavelength range of 550 to 720 nm.

In the resin composition according to one aspect of the present invention, the light absorber may be an inorganic pigment that does not have an absorption maximum wavelength in a visible light region.

In the resin composition according to one aspect of the present invention, the content of the light absorber may be 0.001 to 10% by mass.

In one aspect of the present invention, the resin composition further contains a dye, and the dye is preferably at least one selected from dyes having an absorption maximum wavelength in a wavelength range of 550 to 720 nm.

In one aspect of the present invention, the resin composition further contains a dye, and the dye is preferably at least one selected from dyes having an absorption maximum wavelength in a wavelength range of 590 to 600 nm.

In the resin composition according to one aspect of the present invention, the content of the dye is preferably 0.0005 to 5% by mass.

In the resin composition according to one aspect of the present invention, the transparent resin is preferably at least one selected from an epoxy resin and a silicone resin.

Effects of the Invention

According to the present invention, a resin composition that can obtain a cured product having excellent hue when turning off the light of an optical semiconductor device, improving display contrast and having light transmittance, and an optical semiconductor element and semiconductor device using the resin composition.

Brief Description of the Drawings

[FIG. 1] FIG. 1 is a curve diagram showing the relationship between light transmittance and wavelength in a cured product of the resin composition according to Example 2 of the present invention.

[FIG. 2] FIG. 2 is a curve diagram showing relationship between light transmittance and wavelength in a cured product of the resin composition according to Example 5 of the present invention.

[FIG. 3] FIG. 3 is a curve diagram showing relationship between light transmittance and wavelength in a cured product of the resin composition according to Comparative Example 1.

[FIG. 4] FIG. 4 is a view showing measurement results of light transmittance to BLU (Backlight Unit) in Examples 1 to 10 and Comparative Examples 1 to 3.

[FIG. 5] FIG. 5 is a view showing measurement results of "a" value and "b" value to standard light source D65 in Examples 1 to 10 and Comparative Examples 1 to 3.

[FIG. 6] FIG. 6 is a curve diagram showing an emission spectrum of white LED (RGB LED element) and the relationship between light transmittance and wavelength in Example 2 and Comparative Example 1.

Embodiments for Carrying Out the Invention

The embodiments of the present invention are described in detail below. However, the present invention is not limited to the embodiments described below.

The resin composition according to an embodiment of the present invention is a resin composition containing a transparent resin and a light absorber, and a cured product of the resin composition has an absorption maximum wavelength in a wavelength range of 550 to 720 nm.

The resin composition according to an embodiment of the present invention can be an encapsulation material for an optical conductor.

By that the cured product of the resin composition has an absorption maximum wavelength in a wavelength range of 550 to 720 nm, when used in an optical semiconductor, a display having neutral black when turning off the light can be formed, hue is excellent, and display contrast can be improved.

From the standpoint of brightness, the absorption maximum wavelength is preferably present in a wavelength range of 570 to 700 nm, is more preferably present in a wavelength range of 580 to 690 nm, is still more preferably present in a wavelength range of 580 to 650 nm, and is still further preferably present in a wavelength range of 580 to 600 nm.

Half width of absorption peak showing an absorption maximum wavelength of transmittance when the resin composition has been formed into a cured product is preferably 100 nm or less, more preferably 60 nm or less, and still

more preferably 35 nm or less. By that the half width of the absorption peak showing an absorption maximum wavelength is 100 nm or less, the effect simultaneously bringing about hue improvement when turning off the light and luminance improvement when turning off the light is obtained.

Furthermore, the number of absorption peaks in visible light may be more than one, but from the standpoint of hue when turning off the light and brightness when lighting when used in an optical semiconductor element, the absorption peak is preferably one.

The absorption maximum wavelength of the cured product of the resin composition can be measured by the method described in Examples using a spectrophotometer or the like.

The cured product of the resin composition according to the embodiment of the present invention is preferably dark color, more preferably from gray to black, and still more preferably black. The dark color is that L* defined in L*a*b* color system is 80 or less (0 to 80). Black means black color that L* defined in L*a*b* color system is 35 or less (0 to 35) (preferably 30 or less (0 to 30), and more preferably 25 or less (0 to 25)). In the black, a* value and b* value defined in L*a*b* color system can be appropriately selected according to L* value, respectively. To show neutral black, the a* value and b* value both are preferably -10 to 10, more preferably -5 to 5, and still more preferably a range of -3 to 3 (above all, 0 or almost 0).

The L*a*b* color system is a color space that International Commission on Illumination (CIE) recommended in 1976, and means a color space called CIE 1976 (L*a*b*) color system.

L* value, a* value and b* value defined in the L*a*b* color system can be measured using, for example, integrating sphere. For example, regarding a cured product of a resin composition, spectral reflectance in a wavelength range of 380 to 780 nm is measured with MCPD 9800 manufactured by Otsuka Electronics Co., Ltd., and then tristimulus values X, Y and Z defined in JIS Z 8722:2009 can be calculated. Using the tristimulus values, L* value, a* value and b* value defined in JIS Z 8781-4:2013 are obtained. Light source includes standard light source D65, C, A and the like.

The L* value, a* value and b* value can be adjusted by the selection of the kind and amount of the light absorber contained in the resin composition and the dye as an optional component.

The size of color tone range of the cured product of the resin composition is preferably in a range of MacAdam ellipse 7 step. By this, when the cured product is used in an optical semiconductor device, neutral black display in which reddish tint, yellowish tint and bluish tint are not felt by human eyes can be obtained, and an optical semiconductor device having high designability can be provided.

MacAdam ellipse is that David Lewis MacAdam derived from visual color matching experiment, and indicates standard deviation of discrimination fluctuation to specific central color. From another experiment, it is considered to be preferred that a range that color shift is difficult to understand is about 7 times (7-STEP) of standard deviation.

The resin composition according to the embodiment of the present invention is preferably that the above X, Y, a* and b* satisfy the following formula 1.

Formula 1:

$$((X\cos\theta + Y\sin\theta)/a^*)^2 + ((-X\sin\theta + Y\cos\theta)/b^*)^2 \leq 1$$

$$(a^* = 11.38,\ b^* = 4.66,\ \theta = 124.6°)$$

By that the resin composition satisfies the formula 1, when used in the encapsulation of an optical semiconductor element, hue when turning off the light and brightness when lighting can be improved while improving contrast.

(Transparent resin)

A resin comprising an epoxy resin, a silicone resin, a urethane resin, a urea resin, a phenol resin, polyethylene, polypropylene, polyethylene terephthalate, a vinyl chloride resin, polystyrene, an acrylonitrile-butadiene-styrene copolymer, an acryl resin, polyamide, polyimide, polycarbonate, a melamine resin or the like as a main component can be used as the transparent resin according to the embodiments of the present invention. Above all, from that discoloration due to heat is less and stability to light is high, a resin comprising an epoxy resin or a silicone resin as a main component is preferred, and a resin comprising an epoxy resin as a main component is more preferred.

The epoxy resin includes a bisphenol type epoxy resin such as a bisphenol A type epoxy resin, a bisphenol F type epoxy resin or a bisphenol S type epoxy resin, a novolac type epoxy resin such as a phenol novolac type epoxy resin or a cresol novolac type epoxy resin, a nitrogen ring-containing epoxy resin such as an epoxy resin having an isocyanuric ring skeleton or a hydantoin epoxy resin, a hydrogenated bisphenol A type epoxy resin, hydrogenated bisphenol F type epoxy resin, an aliphatic epoxy resin, a glycidyl ether type epoxy resin, an epoxy resin having aliphatic hydrocarbon as a skeleton such as an alicyclic epoxy resin, a biphenyl type epoxy resin, a dicyclo ring type epoxy resin,

and an epoxy resin that is the mainstream of low water absorption, such as a naphthalene type epoxy resin. Those are used alone or as mixtures of two or more kinds. Of those epoxy resins, from that transparency and discoloration resistance, a bisphenol A type epoxy resin, a bisphenol F type epoxy resin, a novolac type epoxy resin, and alicyclic epoxy resin and an epoxy resin having an isocyanuric ring skeleton are preferably used alone or as mixtures of two or more kinds.

The resin may be solid and may be liquid at ordinary temperatures. However, when using an epoxy resin, an epoxy resin having an average epoxy equivalent of 90 to 1000 is preferred. Furthermore, when the epoxy resin is solid, an epoxy resin having a softening point of 160°C or lower is preferred. When the epoxy resin equivalent is 90 or more, a cured product of the resin composition has sufficient hardness. When the epoxy equivalent is 1000 or less, a glass transition temperature (Tg) of the cured product is high, and heat stability required in an insulation material for an optical semiconductor element can be satisfied.

The curing agent used when a resin comprising an epoxy resin as a main component is used as a transparent resin includes an acid anhydride type curing agent and a phenol type curing agent.

The acid anhydride type curing agent includes phthalic anhydride, maleic anhydride, trimellitic anhydride, pyromellitic anhydride, hexahydrophthalic anhydride, tetrahydrophthalic anhydride, methylnadic anhydride, nadic anhydride, glutaric anhydride, methylhexahydrophthalic anhydride and methyltetrahydrophthalic anhydride. Those are used alone or as mixtures of two or more kinds. Of those acid anhydride type curing agents, phthalic anhydride, hexahydrophthalic anhydride, tetrahydrophthalic anhydride and methylhexahydrophthalic anhydride are preferably used alone or as mixtures of two or more kinds. As the acid anhydride type curing agent, a curing agent having a molecular weight of about 140 to 200 is preferred, and a colorless or light yellowish acid anhydride type curing agent is preferably used.

The phenol type curing agent includes a phenol resin such as resole type phenol resin, novolac type phenol resin, novolac type phenol-formaldehyde resin or polyhydroxystyrene resin, a resole type phenol resin such as aniline-modified resole resin or melamine-modified resole resin, a novolac type phenol resin such as phenol novolac resin, cresol novolac resin, tert-butylphenol novolac resin, nonylphenol novolac resin or naphthol novolac resin, a dicyclopentadiene type phenol resin, a terpene-modified phenol resin, a triphenolmethane type resin, a phenol aralkyl resin having a phenylene skeleton or a diphenylene skeleton, a special phenol resin like a novolac type phenol formaldehyde resin such as naphthol aralkyl resin, and a polyhydroxystyrene resin such as poly(p-hydroxystyrene). Those are used alone or as mixtures of two or more kinds.

The mixing ratio of the epoxy resin and the curing agent is that an active group (an acid anhydride group or a hydroxyl group) capable of reacting with an epoxy group in the curing agent is set to preferably 0.5 to 1.5 equivalents and more preferably 0.7 to 1.2 equivalents, to one equivalent of an epoxy group in the epoxy resin. In other words, when the amount of the active group is too small, a curing rate of the resin composition is slow and additionally a glass transition temperature (Tg) of its cured product tends to be decreased. On the other hand, when the amount of the active group is too large, moisture resistance tends to be deteriorated.

As the curing agent, other than the above acid anhydride type curing agents and phenol type curing agents, other curing agents of epoxy resins can be used depending on its purpose and uses. The curing agents of epoxy resins include an amine type curing agent, curing agents obtained by partially esterifying the above acid anhydride type curing agents with alcohol, and curing agents of carboxylic acid such as hexahydrophthalic acid, tetrahydrophthalic acid or methylhexahydrophthalic acid. Those may be used alone or as mixtures of two or more kinds. Furthermore, those acid anhydride type curing agents may be combined with the above acid anhydride curing agents and phenol type curing agents. For example, when the above curing agent of carboxylic acid has been used together, curing rate can be accelerated and productivity can be improved. Even in the case of using those curing agents, the mixing ratio thereof conforms to the mixing ratio (equivalent ratio) when using an acid anhydride type curing agent and a phenol type curing agent.

When a resin comprising an epoxy resin as a main component is used as the transparent resin, a curing accelerator that is used together with the curing agent includes imidazoles such as 1-benzyl-2-methylimidazole, 1-benzyl-2-phenylimidazole, 2-ethyl-4-methylimidazole, 2-methylimidazole, 2,4-diamino-6-[2'-methylimidazolyl-(1')-ethyl-s-triazine, 2,4-diamino-6-[2'-undecylimidazolyl-(1')]-ethyl-s-triazine, 2-undecylimidazole, 3-heptadecylimidazole, 2-phenylimidazole, 2-phenylimidazoline, 1-benzyl-2-methylimidazole, 1-benzyl-2-phenylimidazole, 1,2-dimethylimidazole, 1-cyanoethyl-2-methylimidazole, 1-cyanoethyl-2-ethyl-4-methylimidazole or 1-cyanoethyl-2-undecylimidazole; tertiary amines such as trimethylamine, triethylamine, dimethyl ethylamine, N-methylpiperazine, N-aminoethylpiperazine, N,N-dimethylaminocyclohexane, N,N-dimethylcyclohexylamine, N,N-dimethylaminobenzene, N,N-dimethylbenzylamine, 1,8-diazabicyclo[5.4.0]undecane-7 or 1,5-diazabicyclo[4.3.0]nonene-5; and phosphorus compound such as triphenylphosphine, tribenzylphosphine or tributylphosphine. The curing accelerator further includes onium salts and metal salts of the above imidazoles, tertiary amines and phosphorus compounds, and their derivatives. Those are used alone or as mixtures of two or more kinds. Of those curing accelerators, imidazoles are preferably used.

When a resin comprising an epoxy resin as a main component is used as the transparent resin, the mixing amount of the curing accelerator is set to an amount of preferably 0.01 to 8% by mass and more preferably 0.1 to 3% by mass, based on the epoxy resin. In other words, when the mixing amount of the curing accelerator is too small,

sufficient curing acceleration effect is difficult to be obtained, and when the mixing amount is too large, the problem such that the cured product obtained discolors becomes easy to be apparent.

(Light absorber)

The light absorber can prevent external light reflection from the surface of an encapsulating resin, the surface of an optical semiconductor element, a frame or an electrode by absorbing external light (such as sunlight or illumination light) in a display and the like of an optical semiconductor element. By this, contrast of an image is increased.

The light absorber preferably does not have an absorption maximum wavelength in a visible light region. By that the light absorber does not have an absorption maximum wavelength in a visible light region, light is equally cut. As a result, it is expected that color drift of a display and the like when lighting the backlight due to the addition of the light absorber is small, or color drift of a display and the like when lighting the backlight due to the addition of the light absorber is easy to be adjusted. Specifically, the visible light region is a wavelength range of 300 to 800 nm.

The light absorber used together with the transparent resin includes coloring materials such as dyestuffs (organic and inorganic) and pigments (organic and inorganic). Pigments are preferably used, and inorganic pigments are more preferably used. Inorganic pigments that do not haven an absorption maximum wavelength in the visible light region are still more preferably used.

As the light absorber, coloring materials showing black are preferred, and specifically include organic dyestuffs such as aniline black or cyanine black; inorganic dyestuffs such as chromium oxide or manganese oxide; and inorganic pigments such as black iron oxide, graphite, titanium black or carbon black. From the standpoints of durability and cost, inorganic pigments are preferred and carbon black is more preferred.

Those light absorbers can be used alone or as mixtures of two or more.

From the standpoint of contrast improvement, the content of the light absorber in the resin composition is preferably 0.001 % by mass or more and more preferably 0.01% by mass or more, based on the total mass of the resin composition. The upper limit of the content of the light absorber in the resin composition is not particularly limited, but is preferably 10% by mass or less.

(Dye)

The resin composition according to the embodiment of the present invention preferably further contains a dye. The dye is not particularly limited and is preferably a dye capable of achieving that an absorption maximum wavelength of a cured product of the resin composition is in a wavelength range of 550 to 720 nm in a visible light region. The dye uses a substance different from the light absorber. In other words, even in dyes that do not have an absorption maximum wavelength in a wavelength range of 550 to720 nm in a single dye, mixed dyes that an absorption maximum wavelength can be in a wavelength range of 550 to 720 nm by combining two or more kinds can be used.

The dye is preferably at least one selected from dyes having an absorption maximum wavelength in a wavelength range of 550 to 720 nm and more preferably at least one selected from dyes having an absorption maximum wavelength in a wavelength range of 590 to 600 nm.

By that the resin composition according to the embodiment of the present invention further contains a dye, a size of color tone range of a cured product is easy to be in a range of MacAdam ellipse 7 step. Furthermore, by selection of the kind of the dye, the adjustment of the amount, and the like, the resin composition is easy to satisfy the formula 1 when the resin composition was formed into a cured product. In particular, by using at least one selected from dyes having an absorption maximum wavelength in a wavelength range of 590 to 600 nm, when the resin composition is used for the encapsulation of an optical semiconductor element, hue when turning off the light and brightness when lighting can be improved while improving contrast.

By combining two or more kinds of the dyes, an absorption maximum wavelength of transmittance when the resin composition has been formed into a cured product is in the above range, half width of an absorption peak showing an absorption maximum wavelength can be narrowed, and excellent hue can be achieved.

The half width of the absorption peak showing the absorption maximum wavelength of transmittance of the dye is preferably 100 nm or less, and for excellent contrast and the improvement of brightness when lighting, the half width is more preferably 60 nm or less and still more preferably 35 nm or less.

The absorption maximum wavelength of the dye can be obtained by, for example, measuring an absorption spectrum of a liquid obtained by diluting a dye to about $10^{-5}$ mol/L with a solvent such as acetone using a spectrophotometer.

The dye having an absorption maximum wavelength in a wavelength range of 550 to 720 nm includes porphyrin dye and squaraine dye. Those are used alone or as mixtures of two or more kinds.

Specifically, as the porphyrin dye, for example, FDR-002, FDR-005, FDG-003, FDG-004 and FDG-007 (all manufactured by Yamada Chemical Co., Ltd.) can be used.

As the squaraine dye, a compound represented by the following formula (1) can be exemplified.
[Chem. 1]

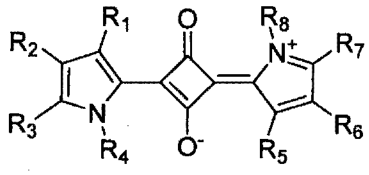

· · · (I)

In the formula (I), $R_1$, $R_2$, $R_3$, $R_4$, $R_5$, $R_6$, $R_7$ and $R_8$ each independently represent an alkyl group having 1 to 20 carbon atoms, that may have hydrogen or a substituent, and $R_2$ and $R_3$ or $R_7$ and $R_8$ may form a ring through a methylene group.

The substituent that the alkyl group having 1 to 20 carbon atoms may have includes an alkyl group, a cycloalkyl group, an aryl group and an alkoxy group. Those substituents may be further substituted with those substituents.

$R_1$, $R_2$, $R_3$, $R_4$, $R_5$, $R_6$ and $R_7$ each independently are preferably an alkyl group having 1 to 10 carbon atoms, more preferably an alkyl group having 1 to 5 carbon atoms and still more preferably 1 to 3 carbon atoms.

$R_2$ and $R_3$ or $R_7$ and $R_8$ preferably form a ring having 5 to 10 carbon atoms through a methylene group, more preferably form a ring having 5 to 8 carbon atoms through a methylene group, and still more preferably form a ring having 5 or 6 carbon atoms through a methylene group.

The ring formed by $R_2$ and $R_3$ or $R_7$ and $R_8$ may further have a substituent, and the further substituent includes an alkyl group having 1 to 5 carbon atoms.

$R_4$ and $R_8$ each independently are preferably an alkyl group having 1 to 20 carbon atoms or an alkyl group having 1 to 5 carbon atoms and having a substituent.

Specific compound represented by the formula (I) includes the following squaraine compound (aquarylium compound).

[Chem. 2]

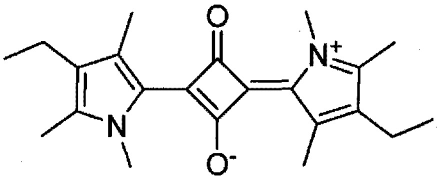
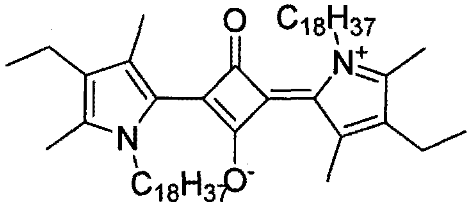
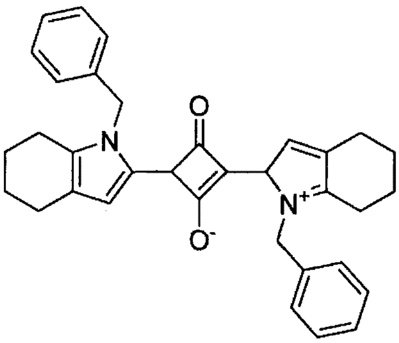
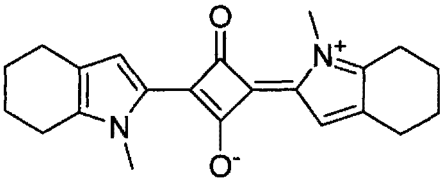
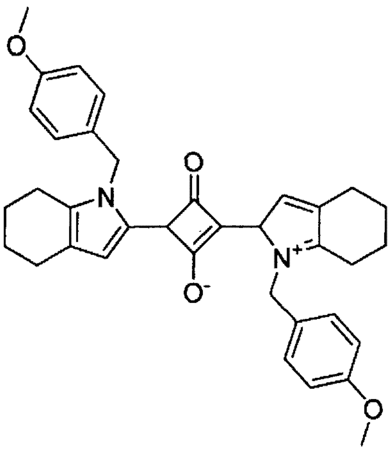
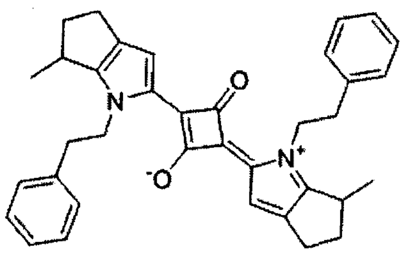

The compound represented by the formula (I) absorbs light emission unnecessary in color expression from a light source, can suppress the light emission and is effective to achieve wide color gamut. Furthermore, the compound is difficult to absorb light emission having high visibility from a light source in the vicinity of 545 nm and therefore can reduce deterioration of luminance.

The compound represented by the formula (I) can be synthesized by the method described in, for example, J. Chem. Soc., Perkin Trans. 2, 1998, 779.

The mixing amount of the dye is preferably 0.0005% mass or more based on the total mass of the resin composition from the standpoint of hue improvement. The mixing amount of the dye is more preferably 0.004% by mass or more from that larger hue improvement effect is obtained. The mixing amount is preferably 5% by mass or less, more preferably 1% by mass or less and still more preferably 0.1% by mass or less.

The light transmittance in a visible light range in the cured product of the resin composition is preferably 20 to 80% and more preferably 40 to 60%. The light transmittance means a value in the case that the thickness of the cured product of the resin composition is 0.3 mm, and the range of the light transmittance varies depending on the thickness of the cured product.

In the resin composition according to the embodiment of the present invention, the light absorber and dye may be added in the state that those have been previously dissolved in an organic solvent.

The organic solvent includes a ketone type solvent such as acetone, methyl ethyl ketone or diethyl ketone, an alcohol type solvent such as methanol, ethanol or isopropyl alcohol, an acid type solvent such as formic acid, acetic acid or butyric acid, an ester type solvent such as formic acid ester such as methyl formate, ethyl formate or propyl formate, acetic acid ester such as methyl acetate, ethyl acetate or propyl acetate, butyric acid ester such as methyl

butyrate, ethyl butyrate or propyl butyrate, and toluene. Those are used alone or as mixtures of two or more kinds. In particular, toluene, methanol, ethanol, isopropyl alcohol, acetone and ethyl acetate are preferably used alone or as mixtures of two or more kinds from that those are industrially and inexpensively available and can be removed by volatilization during the production process of the resin composition. The organic solvent is preferably finally removed, and most of those is volatilized when heating and mixing. However, the resin composition that has been subjected to a treatment under reduced pressure or pulverized is preferably subjected to a treatment of, for example, allowing to stand at a temperature of 60°C or lower for several hours.

The concentration of the light absorber when mixing the light absorber with the organic solvent has a relationship to the mixing amount of the light absorber to the resin composition. However, for example, the concentration is set to a range of preferably 0.1 to 20% by mass and particularly preferably 1 to 20% by mass. In other words, when the concentration is too low, a large amount of an organic solvent is required in order to mixing a necessary amount of the light absorber with the resin composition. As a result, the organic solvent tends to be difficult to be completely removed in a post-process. On the other hand, when the concentration is too high, the concentration of the light absorber is excessively high, and the problem tends to occur such that the light absorber reaches saturation point and is precipitated.

The concentration of the dye in the organic solvent when the dye is mixed with the organic solvent has a relationship to the mixing amount to the resin composition. However, for example, the concentration is set to a range of preferably 0.1 to 20% by mass and particularly preferably 1 to 20% by mass. In other words, when the concentration is too low, a large amount of an organic solvent is required in order to mixing a necessary amount of the dye with the resin composition. As a result, the organic solvent tends to be difficult to be completely removed in a post-process. On the other hand, when the concentration is too high, the concentration of the dye is excessively high, and the problem tends to occur such that the dye reaches saturation point and is precipitated.

In the resin composition of the present invention, when mixing the above components with the organic solvent, the organic solvent in addition to the above each component is used. For the purpose of supplementing characteristics as a resin composition that can be formed into a cured product having excellent hue when turning off the light and high transmittance while maintaining original characteristics of the transparent resin, other additives such as an antioxidant, a deterioration inhibitor, a modifier, a coupling agent, a defoamer, a leveling agent, a release agent, a dyestuff other than the above dye and a pigment may be appropriately added.

The antioxidant and deterioration inhibitor include a phenol type compound, an amine compound, an organic sulfur type compound, a phosphine type compound and a hindered amine type compound. Those are used alone or as mixtures of two or more kinds. The modifier includes glycols, silicones and alcohols. Those are used alone or as mixtures of two or more kinds. The silane coupling agent includes silane type coupling agents such as a titanate type coupling agent, a vinyl type silane coupling agent, an epoxy type silane coupling agent and an amino type silane coupling agent. The defoamer includes a silicone type oil. Those are used alone or as mixtures of two or more kinds.

The resin composition according to the embodiment of the present invention can be obtained as a liquid state, a power state or a tablet state by tableting the powder, by producing as follows.

To obtain a liquid resin composition, for example, a method of directly adding predetermined amounts of a light absorber and a dye to a transparent resin and the like that are each component described above can be used. Alternatively, as a production method of a liquid resin composition, from that the light absorber and dye can be added in high concentration and the formation of an aggregate of the light absorber and dye is suppressed, a method of previously adding a part or the whole of the light absorber and dye to the organic solvent so as to be a predetermined proportion to the whole composition, and adding the light absorber and dye added to the organic solvent together with the remaining components (transparent resin and the like) can be used. Alternatively, as a production method of a liquid resin composition, from that the light absorber and dye can be added without precipitation, a method of previously adding the light absorber and dye to the transparent resin so as to be predetermined amounts based on the whole resin composition and adding the remaining components to the resulting blend can be used.

On the other hand, to obtain a powder state or tablet state (obtained by tableting the powder) resin composition, for example, the resin composition is obtained by appropriately adding a predetermined amount of each component described above, premixing the mixture, kneading the mixture using a kneading machine to melt-mix, cooling the kneaded product to room temperature, pulverizing the kneaded product by the conventional method, and as necessary, tableting the resulting powder.

The resin composition thus obtained according to the embodiment of the present invention can be used as a resin material for encapsulation of an optical semiconductor element such as LED. A method of encapsulating an optical semiconductor element using the resin composition according to the embodiment of the present invention is not particularly limited, and can be performed by the conventional molding method such as ordinary transfer molding or casting.

When the resin composition according to the embodiment of the present invention is a liquid comprising an epoxy resin as a main component, the resin composition can be used as a so-called two-part type in which an epoxy resin and a curing agent are separately stored and are mixed just before use. When the resin composition according to the embodiment of the present invention is a powder state or tablet state comprising an epoxy resin as a main component,

each component is in a state of B stage (semi-cured state) when melt-mixing, and each component can be used by heat-melting when used. The resin composition according to the embodiment of the present invention may be formed into a cured product by thermally curing, and may be formed into a cured product by photo-curing. However, from that discoloration by heating is small and stability to light is high, a thermosetting resin composition is preferably used.

By encapsulating an optical semiconductor element using the resin composition according to the embodiment of the present invention, an optical semiconductor device having excellent hue when turning off the light, showing excellent neutral black, having improved display contrast and having excellent light transmittance while maintaining excellent characteristics (high heat resistance and high adhesion) of the resin composition can be manufactured.

Example

Examples are described below together with Comparative Examples. However, the present invention is not limited to those Examples.

Each component described below was prepared.

[Epoxy resin a]
Bisphenol A type epoxy resin (epoxy equivalent 650)
[Epoxy resin b]
Triglycidyl isocyanurate
[Curing agent a]
Tetrahydrophthalic anhydride
[Curing accelerator]
2-Ethyl-4-methylimidazole
[Black pigment]
Carbon black
[Organic solvent]
Acetone
[Dye]

FDG-004 (manufactured by Yamada Chemical Co., Ltd.)
FDG-007 (manufactured by Yamada Chemical Co., Ltd.)
FDR-002 (manufactured by Yamada Chemical Co., Ltd.)
Dye (no sub peak): Compound shown below

[Chem. 3]

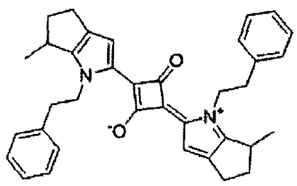

FDG-003 (manufactured by Yamada Chemical Co., Ltd.)
FDR-005 (manufactured by Yamada Chemical Co., Ltd.)

Absorption maximum wavelength (nm) of the above dyes was obtained by measuring absorption spectrum of a liquid obtained by diluting each dye with acetone to the concentration of about $10^{-5}$ mol/L using a spectrophotometer.

[Table 1]

Table 1

| Dye | Half width (nm) | Absorption maximum wavelength (nm) |
|---|---|---|
| FDG-004 | 95 | 583 |

(continued)

| Dye | Half width (nm) | Absorption maximum wavelength (nm) |
|---|---|---|
| FDG-007 | 31 | 595 |
| FDR-002 | 38 | 683 |
| Dye (no sub peak) | 31 | 591 |
| FDG-003 | 72 | 547 |
| FDR-005 | 40 | 725 |

[Examples 1 to 10 and Comparative Examples 1 to 3]

A target resin composition was prepared by adding and mixing each component shown in Table 2 below in the proportion shown in the Table. In the Examples and Comparative Examples, a resin composition was prepared by adding a dye (excluding black pigment) to an organic solvent (acetone) in advance and mixing the resulting mixture with the remaining other compounding components. Almost all of acetone as the organic solvent was volatilized and removed when mixing.

The resin composition thus obtained was molded by transfer molding method at 150°C for 4 minutes using an exclusive mold (thickness of molding portion 0.3 mm), and a resin cured product (thickness 0.3 mm) was prepared by conducting post heat-curing at 150°C for 3 hours. Transmission spectrum of the resin cured product was measured using a spectrophotometer (Hitachi spectrophotometer U-4100). The results [curve diagrams showing the relationship of vertical axis: transmittance (%/0.3 mm) and horizontal axis: wavelength (nm)] are shown in FIGS. 1 to 3. FIG. 1 shows Example 2, FIG. 2 shows Example 5 and FIG. 3 shows Comparative Example 1.

In the above measurement results, the cured products of the resin compositions of Examples 1 to 10 each have an absorption maximum wavelength in a wavelength range of 550 to 720 nm.

The resin compositions prepared above each were placed on a standard reflector and in order to make the respective lightness (L*) constant, each component was added such that reflectance to standard light D65 is 21.6%. Regarding the reflectance of the cured product of the resin composition, external light reflectance (visual weighted average) was measured using a spectrometer (MCPD 9800 manufactured by Otsuka Electronics Co., Ltd.).

(L*, a* and b* values)

Regarding the cured products of the resin compositions prepared above, spectral reflectance of each sample was measured with Otsuka Electronics MCPD 9800 using standard light D65 as a light source similar to the measurement of the reflectance, and tristimulus values X, Y and Z defined in JIS Z 8722:2009 were then measured. Using the tristimulus values, L* value, a* value and b* value defined in JIS Z 8781-4: 2013 were obtained.

The relationships of the measurement results of a* value and b* value to standard light D65 in Examples 1 to 10 and Comparative Examples 1 to 3 are shown in FIG. 5.

(Transmittance of BLU light (white))

Regarding the cured product of each resin composition prepared above, the transmittance (visual weighted average) was calculated using spectrum of white LED light source for BLU (RGB LED element) under spectral transmittance measured with a spectrophotometer (U-4100 manufactured by Hitachi High-Tech Corporation). By calculating the transmittance to BLU light, the transmittance can be an index of brightness when lighting of an optical semiconductor device.

Regarding Examples 1 to 10 and Comparative Examples 1 to 3, the calculation results of the transmittance of BLU light are shown in FIG. 4.

Those results are also shown in Table 2 below.

Table 2

| | | Ex. 1 | Ex. 2 | Ex. 3 | Ex. 4 | Ex. 5 | Ex. 6 | Ex. 7 | Ex. 8 | Ex. 9 | Ex. 10 | Com. Ex. 1 | Com. Ex. 2 | Com. Ex. 3 |
|---|---|---|---|---|---|---|---|---|---|---|---|---|---|---|
| Epoxy resin a | Parts added | 80 | 80 | 80 | 80 | 80 | 80 | 80 | 80 | 80 | 80 | 80 | 80 | 80 |
| Epoxy resin b | Parts added | 20 | 20 | 20 | 20 | 20 | 20 | 20 | 20 | 20 | 20 | 20 | 20 | 20 |
| Curing agent a | Parts added | 49 | 49 | 49 | 49 | 49 | 49 | 49 | 49 | 49 | 49 | 49 | 49 | 49 |
| Curing accelerator | Parts added | 0.5 | 0.5 | 0.5 | 0.5 | 0.5 | 0.5 | 0.5 | 0.5 | 0.5 | 0.5 | 0.5 | 0.5 | 0.5 |
| Black pigment | Parts added | 0.030 | 0.033 | 0.037 | 0.030 | 0.033 | 0.036 | 0.030 | 0.030 | 0.031 | 0.037 | 0.028 | 0.030 | 0.030 |
| FDG-007 | Parts added | 0.0047 | 0.0132 | 0.0220 | | | | | | 0.0037 | 0.0119 | | | |
| Dye (no sub peak) | Parts added | | | | 0.0040 | 0.0137 | 0.0222 | | | | | | | |
| FDG-004 | Parts added | | | | | | | 0.0022 | | | 0.0047 | | | |
| FDR-002 | Parts added | | | | | | | | 0.0253 | 0.0090 | | | | |
| FDG-003 | Parts added | | | | | | | | | | | | 0.0034 | |
| FDR-005 | Parts added | | | | | | | | | | | | | 0.0253 |
| Absorption maximum (minimum) peak wavelength of cured product | | 594 | 594 | 594 | 590 | 590 | 590 | 577 | 681 | 680 | 594 | - | 547 | 725 |
| L* | | 53.6 | 53.6 | 53.6 | 53.6 | 53.6 | 53.6 | 53.6 | 53.6 | 53.6 | 53.6 | 53.6 | 53.6 | 53.6 |
| a* | | 1.8 | 0.7 | 0.8 | 1.8 | -0.2 | -0.9 | 4.0 | -9.1 | -4.3 | 5.0 | 2.7 | 10.4 | -7.7 |
| b* | | 7.3 | -0.4 | -8.6 | 8.0 | -0.4 | -7.4 | 8.2 | 8.2 | 5.1 | -6.0 | 11.2 | 8.1 | 14.7 |

(continued)

| | Ex. 1 | Ex. 2 | Ex. 3 | Ex. 4 | Ex. 5 | Ex. 6 | Ex. 7 | Ex. 8 | Ex. 9 | Ex. 10 | Com. Ex. 1 | Com. Ex. 2 | Com. Ex. 3 |
|---|---|---|---|---|---|---|---|---|---|---|---|---|---|
| Transmittance of BLU light (visual weighted average) | 46.9% | 48.6% | 49.9% | 47.1% | 49.7% | 51.4% | 46.4% | 46.0% | 46.7% | 49.0% | 46.0% | 45.5% | 46.1% |
| External light reflectance (visual weighted average) | 21.60% | 21.60% | 21.60% | 21.60% | 21.60% | 21.60% | 21.60% | 21.60% | 21.60% | 21.60% | 21.60% | 21.60% | 21.60% |

(Transmittance of R, G, B LED elements (when lighting alone))

As the emission spectra of R, G and B three color LED elements (3 LED) and the transmittance of the cured products of Example 2 and comparative Example 1 are shown in FIG. 6, it is understood that the cured product of Example 2 has high light transmittance at wavelengths of 463 nm, 530 nm and 615 nm as compared with Comparative Example 1, and luminance is excellent to not only white light but single lighting of R, G, B LED elements.

From the above results, the cured products of the examples all have a* value and b* value that are within a range of ±10, and the results were that when used in an optical semiconductor device, neutral black can be shown. Examples 2, 3, 5, 9 and 10 are within the range of MacAdam ellipse 7 step, and the results were that hue improvement is particularly excellent.

Using each resin composition of the above Examples, an optical semiconductor device was prepared by molding a light receiving element (1.5 mm × 1.5 mm × 0.37, silicon photodiode) by transfer molding (150°C × 4 minutes molding, 150°C × 3 hours post heat-curing) using an exclusive mold. This optical semiconductor device is a small outline package (SOP) 8 pin of 4 mm × 5 mm having a lead frame comprising 42 alloy, the entire surface of which being plated with silver. The optical semiconductor device obtained had problem-free high reliability.

Industrial Applicability

The resin composition of the present invention can be used in an encapsulation material of an optical semiconductor element, has excellent hue of an optical semiconductor device when turning off the light, improves display contrast, and can obtain a cured product having light transmittance.

Although the present invention has been described in detail and by reference to the specific embodiments, it is apparent to one skilled in the art that various modifications or changes can be made without departing the spirit and scope of the present invention.

This application is based on Japanese Patent Application No. 2018-185893 filed September 28, 2018, the disclosure of which is incorporated herein by reference.

## Claims

1. A resin composition containing a transparent resin and a light absorber,
   wherein a cured product of the resin composition has an absorption maximum wavelength in a wavelength range of 550 to 720 nm.

2. The resin composition according to claim 1, wherein the light absorber is an inorganic pigment that does not have an absorption maximum wavelength in a visible light region.

3. The resin composition according to claim 1 or 2, wherein the content of the light absorber is 0.001 to 10% by mass.

4. The resin composition according to any one of claims 1 to 3, further containing a dye, wherein the dye is at least one selected from dyes having an absorption maximum wavelength in a wavelength range of 550 to 720 nm.

5. The resin composition according to any one of claims 1 to 4, further containing a dye, wherein the dye is at least one selected from dyes having an absorption maximum wavelength in a wavelength range of 590 to 600 nm.

6. The resin composition according to claim 5, wherein the content of the dye is 0.0005 to 5% by mass.

7. The resin composition according to any one of claims 1 to 6, wherein the transparent resin is at least one selected from an epoxy resin and a silicone resin.

Fig. 1

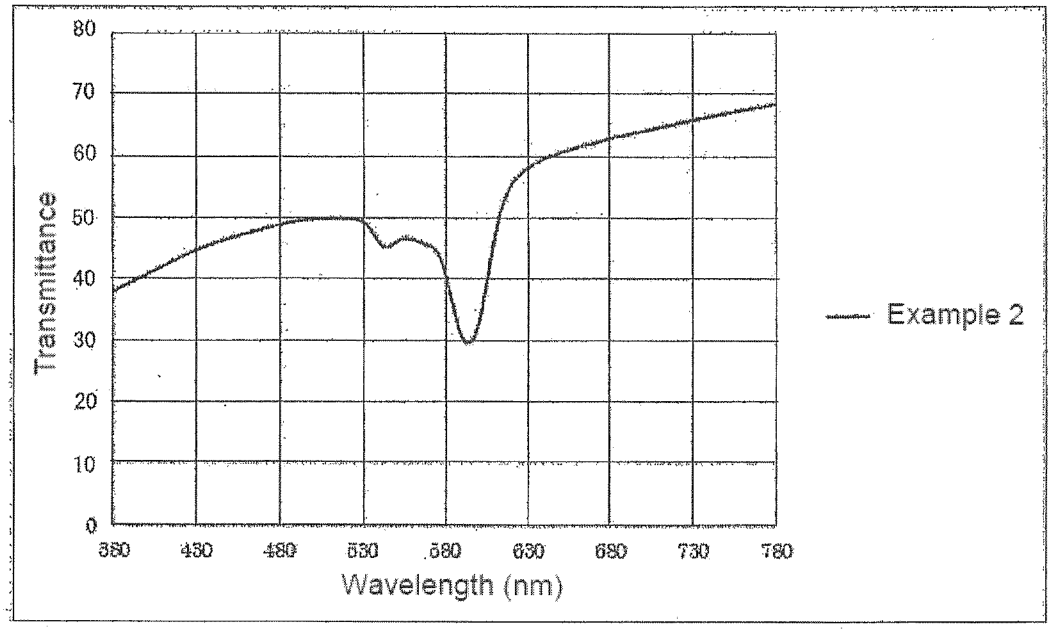
80
70
60
50
40
30
20
10
0
Transmittance
380
430
480
530
580
630
680
730
780
Wavelength (nm)
Example 2

Fig. 2

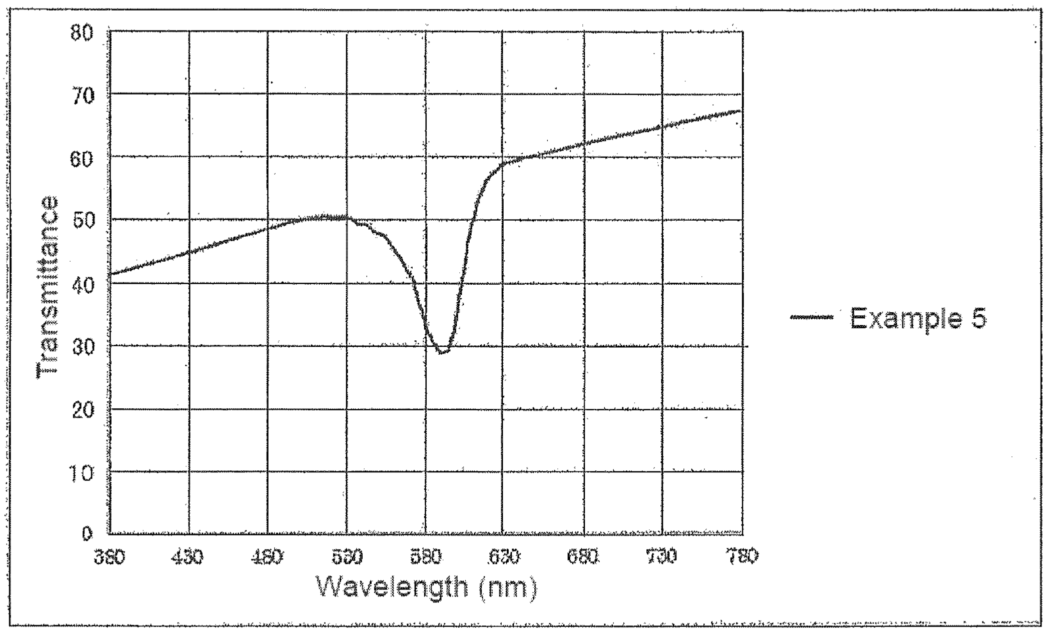
80
70
60
50
40
30
20
10
0
Transmittance
380
430
480
530
580
630
680
730
780
Wavelength (nm)
Example 5

Fig. 3

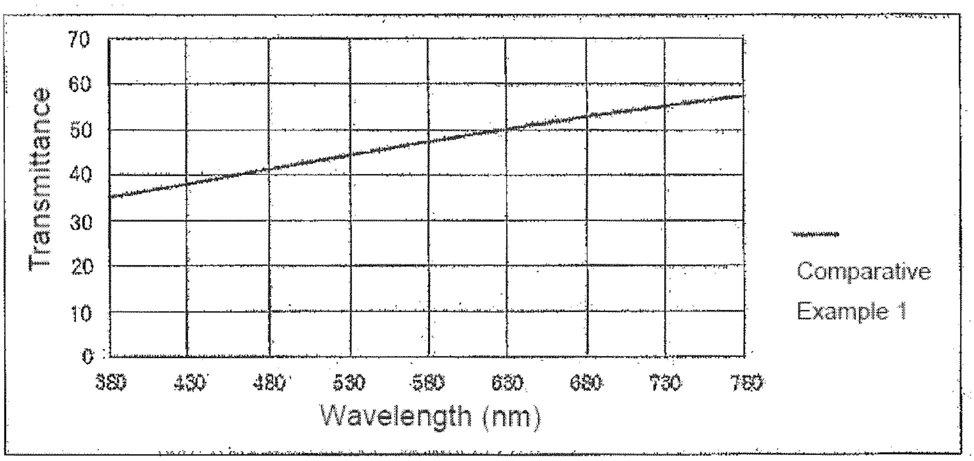
Transmittance
70
60
50
40
30
20
10
0
380
430
480
530
580
630
680
730
780
Wavelength (nm)
Comparative Example 1

Fig. 4

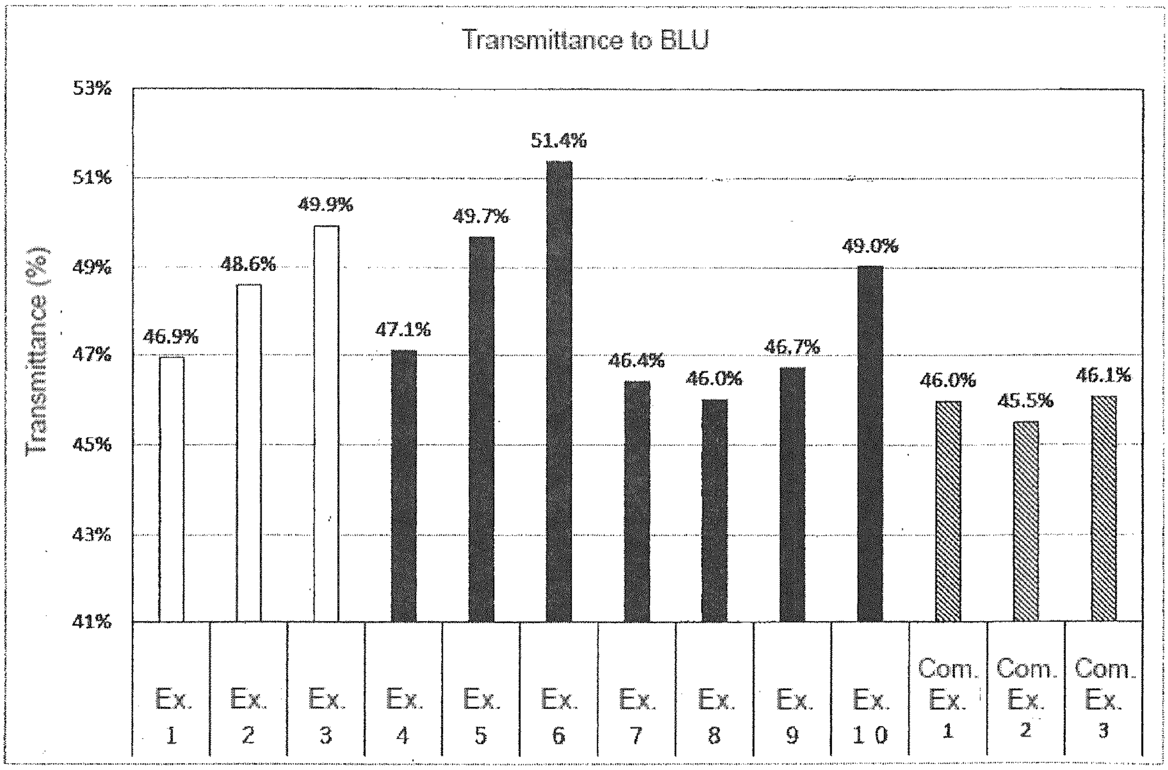
Transmittance to BLU
Transmittance (%)
53%
51%
49%
47%
45%
43%
41%
46.9%
48.6%
49.9%
47.1%
49.7%
51.4%
46.4%
46.0%
46.7%
49.0%
46.0%
45.5%
46.1%
Ex. 1
Ex. 2
Ex. 3
Ex. 4
Ex. 5
Ex. 6
Ex. 7
Ex. 8
Ex. 9
Ex. 10
Com. Ex. 1
Com. Ex. 2
Com. Ex. 3

Fig. 5

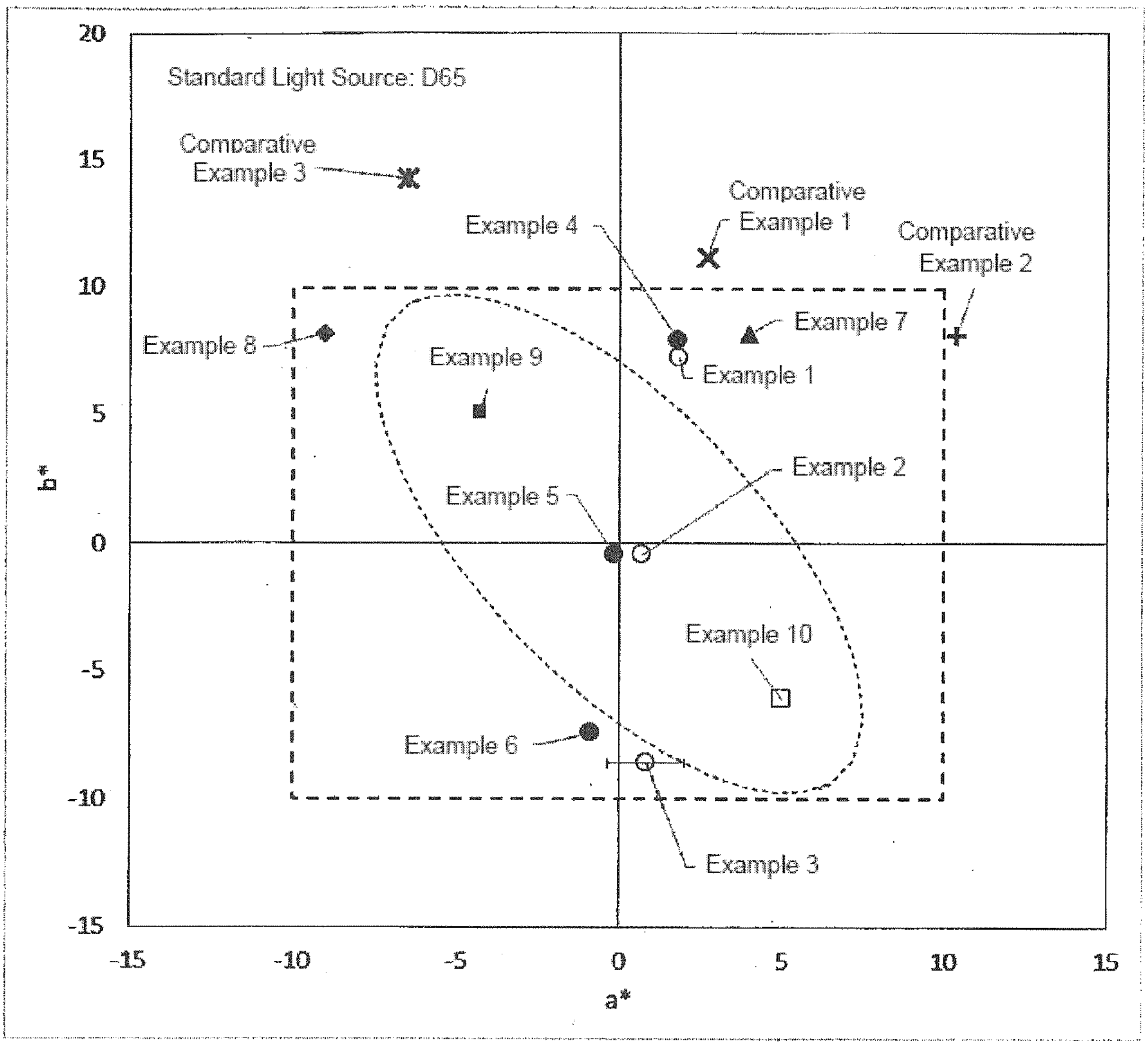
Standard Light Source: D65
Comparative Example 3
Comparative Example 1
Comparative Example 2
Example 1
Example 2
Example 3
Example 4
Example 5
Example 6
Example 7
Example 8
Example 9
Example 10
b*
a*
20
15
10
5
0
-5
-10
-15
-15
-10
-5
0
5
10
15

Fig. 6

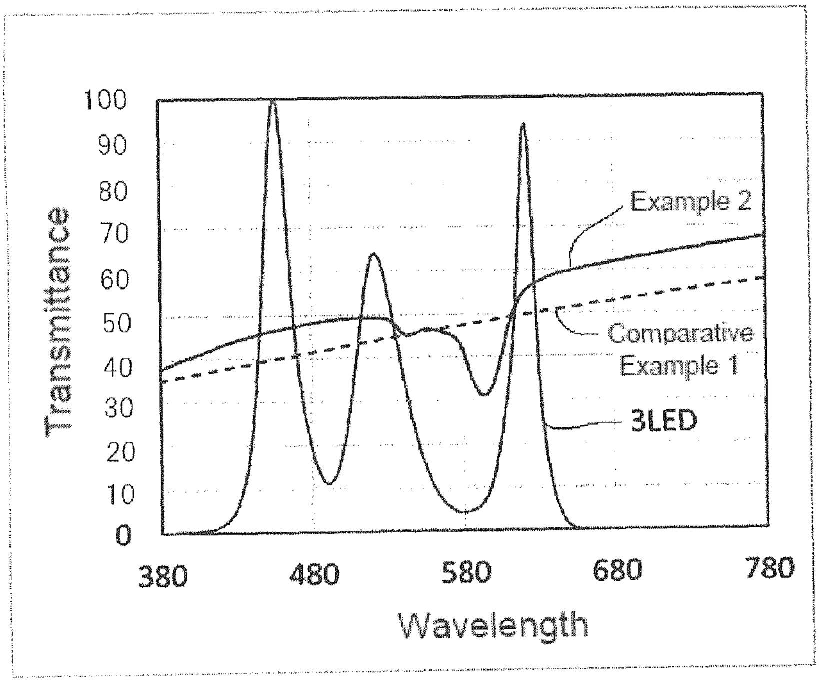
100
90
80
70
60
50
40
30
20
10
0
Transmittance
380
480
580
680
780
Wavelength
Example 2
Comparative Example 1
3LED

## INTERNATIONAL SEARCH REPORT

International application No.
PCT/JP2019/038425

A. CLASSIFICATION OF SUBJECT MATTER
Int.Cl. C08L101/12(2006.01)i, C08K3/00(2018.01)i, C08K5/00(2006.01)i, C08L63/00(2006.01)i, C08L83/04(2006.01)i, H01L33/56(2010.01)i

According to International Patent Classification (IPC) or to both national classification and IPC

B. FIELDS SEARCHED

Minimum documentation searched (classification system followed by classification symbols)
Int.Cl. C08L101/12, C08K3/00, C08K5/00, C08L63/00, C08L83/04, H01L33/56

Documentation searched other than minimum documentation to the extent that such documents are included in the fields searched

| | |
|---|---|
| Published examined utility model applications of Japan | 1922-1996 |
| Published unexamined utility model applications of Japan | 1971-2019 |
| Registered utility model specifications of Japan | 1996-2019 |
| Published registered utility model applications of Japan | 1994-2019 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| X | JP 2015-86357 A (TAIYO INK MFG. CO., LTD.) 07 May 2015, claims, examples & KR 10-2015-0035420 A & TW 201523131 A & KR 10-2015-0035419 A & TW 201529747 A | 1-7 |
| X<br>A | JP 2016-115779 A (DAICEL CORPORATION) 23 June 2016, claims, examples (Family: none) | 1, 3-7<br>2 |

☒ Further documents are listed in the continuation of Box C. ☐ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| 21 November 2019 (21.11.2019) | 03 December 2019 (03.12.2019) |

| Name and mailing address of the ISA/ | Authorized officer |
|---|---|
| Japan Patent Office<br>3-4-3, Kasumigaseki, Chiyoda-ku,<br>Tokyo 100-8915, Japan | Telephone No. |

Form PCT/ISA/210 (second sheet) (January 2015)

**INTERNATIONAL SEARCH REPORT**

International application No.
PCT/JP2019/038425

C (Continuation). DOCUMENTS CONSIDERED TO BE RELEVANT

| Category* | Citation of document, with indication, where appropriate, of the relevant passages | Relevant to claim No. |
|---|---|---|
| X<br>A | JP 2014-137462 A (DAINIPPON PRINTING CO., LTD.) 28 July 2014, claims, examples (Family: none) | 1, 3-7<br>2 |
| X<br>A | JP 7-325391 A (NEW OJI PAPER CO., LTD.) 12 December 1995, claims, examples (Family: none) | 1, 3-6<br>2, 7 |

Form PCT/ISA/210 (continuation of second sheet) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*


### Patent documents cited in the description

- JP 2003086846 A
- JP 2018185893 A

### Non-patent literature cited in the description

- *J. Chem. Soc., Perkin Trans.,* 1998, vol. 2, 779